# EUROPEAN PATENT SPECIFICATION

(11) **EP 1 266 426 B1**
(45) Date of publication and mention of the grant of the patent: **29.08.2007**
(21) Application number: 01920313.2
(22) Date of filing: 13.03.2001
(51) Int. Cl.: H01Q 1/36

(54) **METHOD FOR FORMING RADIO FREQUENCY ANTENNA USING CONDUCTIVE INKS**
VERFAHREN ZUR BILDUNG EINER HOCHFREQUENZANTENNE AUS LEITFÄHIGEN TINTEN
PROCEDE DE FORMATION D'UNE ANTENNE RADIOFREQUENCE AU MOYEN D'ENCRES CONDUCTRICES

(30) Priority: 13.03.2000 US 524505
(43) Date of publication of application: 18.12.2002
(60) Divisional application: 07004141.3
(73) Proprietor: RCD Technology, Inc., East Winsor, NJ 08520 (US)
(72) Inventor: OBERLE, Robert, R., East Winsor, NJ 08520 (US)
(74) Representative: Gosnall, Toby
(86) International application number: PCT/US2001/007897
(87) International publication number: WO 2001/069717

(56) References cited:
- EP-A- 0 903 805
- US-A- 4 560 445
- US-A- 5 541 399
- US-A- 5 598 032
- US-A- 5 892 661
- US-A- 5 903 239
- US-A- 5 909 050
- US-A- 6 023 961
- US-A- 6 049 461

## Description

### Background of the Invention

The present invention relates to methods of manufacture of flexible circuits used in construction of radio frequency (RF) antennae.

Radio frequency antennae are typically made in a conductive coil pattern. The conductive coil pattern allows the antenna to receive and radiate energies in the radio frequency range. Typically, the antenna is optimized to transmit and receive energy in a relatively narrow portion of the radio frequency range.

Radio frequency antennae are used in a number of different areas including inventory control. Often the radio frequency antenna is connected to an integrated circuit.

The integrated circuit receives energy from a detector unit, modulates the energy with an identification pattern stored in the integrated circuit, and then retransmits the modulated energy to the detector unit. Such inventory control units, including the radio frequency antennae, can be made quite inexpensively.

One way of forming a radio frequency antenna is to stamp out a conductive coil out of a sheet of metal. The downside of this method is that the production of the metal coil results in a large amount of scrap metal. Additionally, the radio frequency antennae produced by stamping from a sheet of metal may be stiffer than desired.

Another way of forming the radio frequency antenna is to use strip-back techniques common in printed circuit (PC) board fabrication. In PC board fabrication, a layer of the conductive material is formed on top of a substrate, and the areas not used for the antenna are stripped away. This method tends to be wasteful when used to produce the radio frequency antenna, because the radio frequency coil antenna tends to be about 10% of the surface area of the substrate. This compares to coverage areas of 70 -80% common with typical PC board implementations.

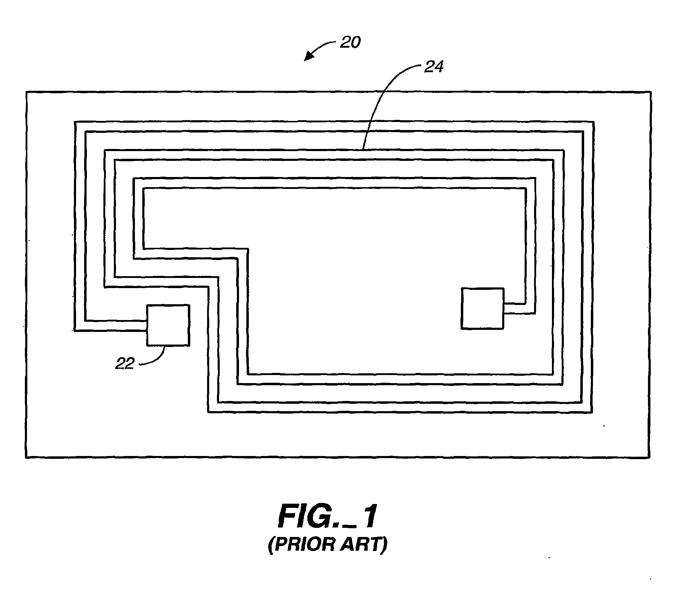

Another way of forming a radio frequency antenna is to use conductive inks. Typically, the conductive ink is printed In a RF antenna coil pattern on top of the substrate. The conductive ink is then cured. The printed antennae may be used as is or electrodes are attached to the conductive ink pattern and a metal layer is electroplated on top of the conductive ink pattern. Figure1 illustrates this prior art embodiment. The electrode is attached to pad 22 to electroplate the metal material on top of the conductive ink pattern. Because of its cost, the conductive ink material tends to be applied in relatively narrow and thin layers. This means that when a voltage source is attached to pad 22, there is considerable electrical resistance between pad 22 and point 24 near the centre of the pattern. Due to this electrical resistance, the electroplated material preferentially coats the areas near the electrode at pad 22, rather than position 24. This makes it difficult to obtain a proper electroplated coating on top of the conductive ink.

One possible solution is to use the conductive ink with a thicker or wider pattern, thus reducing the resistance per length of the conductive ink strip. The downside of this solution is that the conductive ink is expensive compared to the much cheaper electroplated material.

An example of the art is provided by EP 0 903 805-A2, which describes a method for electroplating a pattern formed of conductive ink.

For the above reasons, it is desired to have an improved method of forming a radio frequency antenna.

### Summary of the Present Invention

The present invention is a method and apparatus of forming a flexible circuit for use as a radio frequency antenna which uses a temporary electrical-short layer. A seed layer, such as a conductive ink layer, is formed In the coil antenna pattern on a substrate. An electrical-short layer pattern of a conductive material is placed over the coils, such that the coil is electrically shunted together. An insulating layer is formed over top of the electrical-short layer. Next, electroplating occurs, so that the electroplated material forms over top of the seed layer. There is no plating on the electrical short layer when protected by the insulating layer. After plating, the electrical-short layer and the insulating layer are then removed.

The use of the electrical-short layer has the advantage that it allows the resistance between the electrode and the other locations on the conductive ink layer to be reduced. The electrical-short layer effectively results in a more uniform electroplating on all the points on the radio frequency coil pattern. This avoids the problem that occurred in the prior art of requiring a relatively thick conductive ink layer. In the method of the present invention, an effectively uniform conductive electroplate layer can be produced.

Another embodiment of the present invention is a radio frequency antenna, which is formed by the method of the present invention. This radio frequency antenna includes a substrate, a conductive ink layer in the form of an antenna coil, and a conductive electroplate layer on top of the conductive ink layer, with the conductive electroplate layer having a removed short region. The removed short region comprises a portion of the seed layer not covered by the conductive material

Detailed further for background relevance is a method which comprises: providing a substrate layer; forming one or more holes in the substrate layer; attaching a conductive foil layer on one or both sides of the substrate layer, such that the conductive foil covers the holes; and forming conductive layer (s) on one (both) sides of the substrate in an antenna coil pattern, with the conductive ink to form an electric contact with the metal foil. The conductive ink has the advantage that it can easily go into the holes to form that connection to a conductive foil and the circuit elements on the substrate. Prior ways of forming a connection between two sides of the substrate for the radio frequency antenna include punching holes through a conductive metal layer to a conductive metal layer on the other side of the substrate. The punch would hopefully force some metal on the one layer to contact the metal on the other layer. This has the downside of it being unreliable and prone to failure during the operation of the radio frequency antenna.

Detailed further for background relevance is a method for forming an RF antenna comprising providing a substrate layer, forming at least one hole in the substrate layer, and putting conductive ink within the at least one hole to form an electrically conductive connection between a conductive ink layer on one side of the substrate in at least part of an antenna coil pattern and a second conductive ink layer on the other side of the substrate. The two conductive ink layers can be formed before the hole-forming step, or forming one of the conductive ink layers can cause conductive ink to connect between the two sides of the substrate in some cases, no metal shunt is required but conductive Ink formed in the hole can later be plated so that the two-sided antenna structure can be formed. Here, it is important that the conductive ink does not completely fill the hole so as to allow space for the more highly conductive plating material.

The filling of the hole can be done by capillary action with a pad with ink which touches the area over the hole. This also may be achieved when no backing is used. Backings may pool the conductive ink. Alternatively a backing with a cavity may be used. The conductive ink will partially fill the cavity rather than wicking between the substrate and the remainder of the backing.

Detailed further for understanding is the situation when a conductive layer Is printed over the hole and there is an unprinted region within at least part of the hole. This prevents too much of the conductive ink from going into the hole and potentially filling the hole before the plating process. Furthermore, an unprinted circular region within the diameter of the hole is provided. This allows some of the ink to wick down the sides into the hole without causing too much conductive ink to be placed within the hole.

### Brief Description of the Drawings

Figure1 is a diagram of a prior art radio frequency antenna.
Figure 2 is a diagram illustrating the construction of the radio frequency antenna of the present invention using an electrical-short layer.
Figure 3 is a detail of a top view of the electrical-short layer placed on top of the loops of the conductive ink coil pattern of one embodiment of the present invention.
Figures 4A-4E are cross-sectional diagrams illustrating the construction of the radio frequency antenna according to one embodiment of the present invention.
Figure 5 illustrates a detail of one embodiment of a radio frequency antenna constructed by the method of one embodiment of the present invention.
Figure 6 is a flow chart illustrating one method of the present invention.
Figures 7A-7C are diagrams illustrating the construction of a radio frequency antenna as an example cited as useful for understanding the present invention.
Figures 8A-8D are cross-sectional diagrams illustrating the construction of the radio frequency antenna according to Figures 7A-7C.
Figures 9A-9C illustrate details of a cross-sectional view for the method detailed here as background relevance.
Figures10A-10C illustrate a top view for the cross-sectional views of Figures 9a-9C.
Figure11A illustrates a top view of a printing design.
Figure11 B illustrates the conductive ink layers formed on two sides of the substrate.
Figures 12A and 12B, illustrate the use of a backing material with a cavity.

### Detailed Description of the Preferred Embodiment

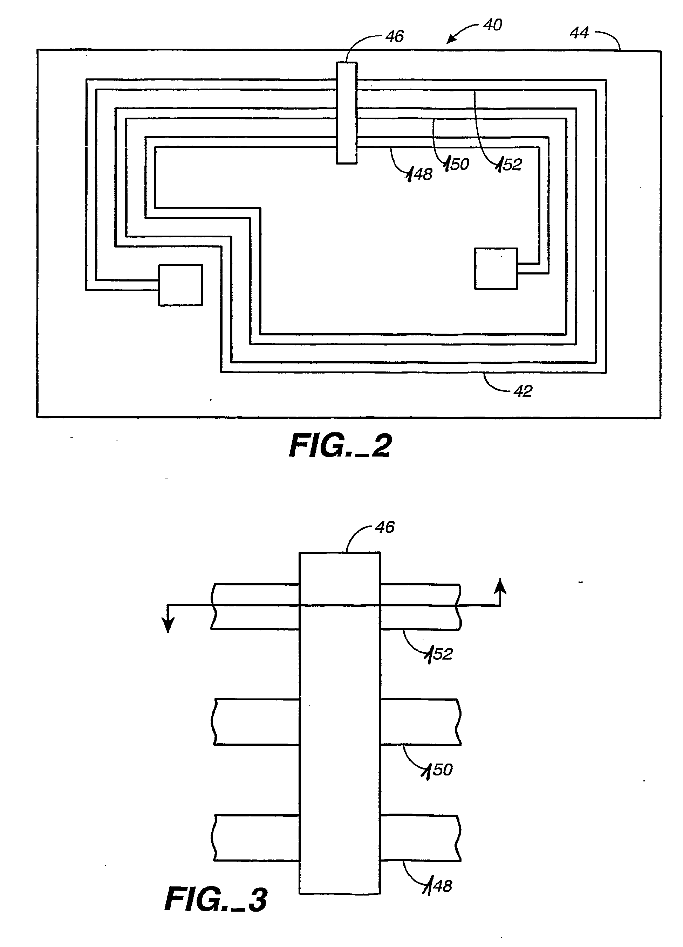

Figure2 is a top view of a radio frequency antenna 40 being constructed by the method of one embodiment of the present invention. The radio frequency antenna 40 includes a conductive ink pattern 42 formed in a coil on the substrate 44. An electrical short layer 46 is formed over top of the conductive ink coil pattern, and preferably a nonconductive plating resist is formed over the short. The electrical-short layer 46 ensures that points 148, 160 and 152 on the conductive ink pattern 42 will have relatively similar voltages during the electroplating process. This means all locations on the conductive ink pattern 42 will be electroplated evenly. Thus the apparatus of the present invention allows for a conductive electroplate layer of sufficient thickness on all points of the radio frequency antenna.

The use of the electrical-short layer 46 allows for the use of a thinner and/or narrower conductive ink layer 42. The resistance of the conductive ink layer during the electroplate process is not as important a factor because the electrical-short layer is used.

Typically it is desired to minimize the resistance of the radio frequency antenna. A desirable property of radio frequency antennae is to have a relatively high Q factor. The Q factor for an antenna is defined-as the imaginary over the real part of the impedance. The imaginary part of the impedance is typically a function of the desired operating frequency and geometry and is typically fixed. Thus, to produce a high Q factor antenna, the resistance of the antenna should be kept as small as possible. This means that it is desired to have a relatively thick conductive metal layer forming the coils of the radio frequency antenna. The use of the electrical-short layer of the present invention aids in the construction of a uniformly thick electroplate layer, thus lowering the resistance and raising the Q factor.

Figure 3 is a detail of a portion of Figure 2.

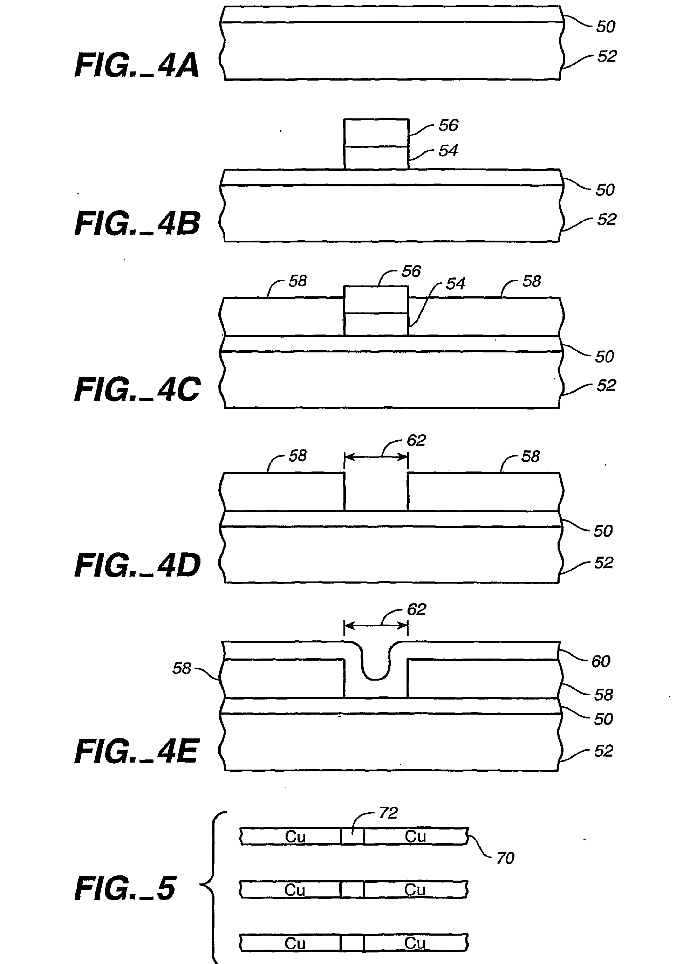

Figures 4A-4E are cross-sectional views illustrating the construction of one embodiment of the radio frequency antenna of the present invention. In Figure 4A, a conductive seed layer 50 is formed on top of the substrate 52. In the preferred embodiment, the substrate 52 is a flexible substrate which allows the constructed radio frequency antenna to bend. One example of a flexible substrate material which is suitable for use with the present invention is Mylarg, polyester film from E.I. DuPont de Nemours, Wilmington, DE. A conductive seed layer 50 is formed in a coil pattern shown with respect to Figure 2 above. In one embodiment of the present invention, the conductive seed layer 50 is a conductive ink layer. The conductive ink layer could be of the type such as EnTouch EN-079 from Engelhard Corporation Iselin NJ In Figure 4B, the electrical-short layer material 54 Is formed over top of the coil pattern 50. The electrical short ink layer could be of the type such as EnTouch EN-081 from Engelhard Corporation Iselin NJ. An additional insulating layer 56 is preferably formed on top of the electrical-short layer 64. The insulating ink layer could be of the type such as EnTouch EN-080 from Engelhard Corporation Iselin NJ. The conductive ink layer 60 can be printed upon the flexible substrate, as is known in the prior art. In one embodiment, the electrical-short layer 54, and the insulating layer, 56 are differentially removable (for example soluble in a solvent that the initial seed layer is impervious to) from the conductive ink material. Figure 4C illustrates the results of the electroplating, in which a conductive material 58 is formed over top of the conductive ink layer 50. The insulating layer 56 preferably prevents an electroplate layer from forming on the electrical-short layer. The conductive layer 58 is preferably an inexpensive metal material. In one embodiment of the present invention, the conductive layer 58 is made of copper. In Figure 4D. the electrical-short layer 54 and the insulating layer 56 are stripped away. The stripping can be done using a solvent, ashing, reactive gas or any other method.

In an alternate embodiment of the present invention, the electrical-short layer 54 is constructed of metallic foil, which could be attached to the RF antenna and then removed after the electroplating. Figure 4E shows an optional additional step of a second electroplating in which an additional electroplate layer 60 is formed on top of the first electroplate layer 58. The advantage of the second electroplate step is that it allows for some electroplate material to go into the removed short layer region 62.

Figure 5 illustrates a detail of the formed radio frequency antenna produced with the method of one embodiment of the present invention. Note that most of the radio frequency antenna includes electroplated copper portions 70, but the small removed electrode portion 72 consists of the conductive ink layer by itself. As long as the removed short region 72 remains relatively thin, the total increased resistance caused by the removed short region 72 will not be too high. In fact, the total resistance of the radio frequency antenna is reduced as a result of the more effective electroplating of the present invention.

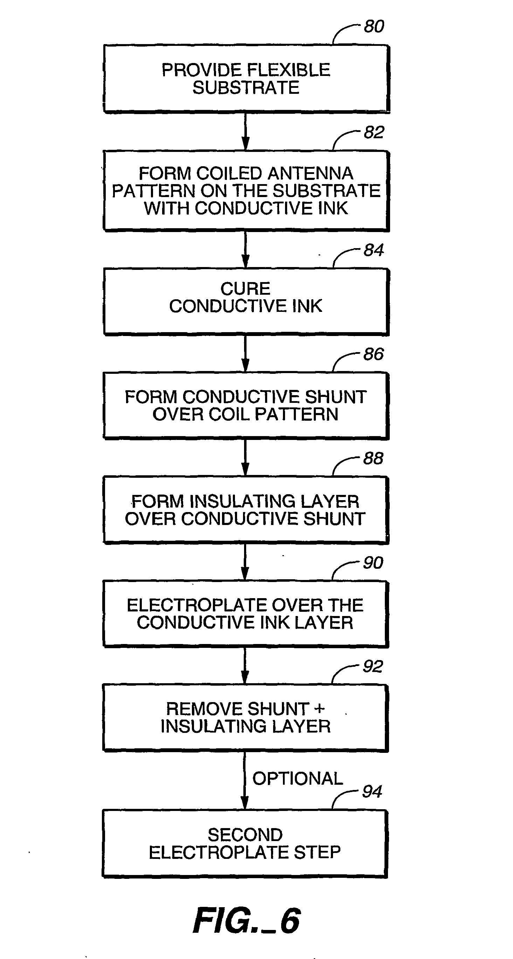

Figure 6 is a flow chart illustrating one embodiment of the present invention. In Step 80, a flexible substrate is provided. In Step 82, a coil antenna pattern is formed on the substrate with the conductive ink. In Step 84, the conductive ink is cured. In Step 86, an electrical-short layer is formed over a portion of the coil pattern. In a preferred embodiment, the electrical-short layer is formed of differentially removable conductive ink. In Step 88, an insulating layer is formed over the electrical-short layer. In Step 90, the electroplating is done to form a conductive electroplate layer on the conductive ink layer. In Step 92. the electrical-short layer and Insulating layer are removed. This is preferably using a solvent that removes the electrical-short layer and insulating layer, yet does not affect the cured conductive ink layer. Step 94 is an optional second electroplating step.

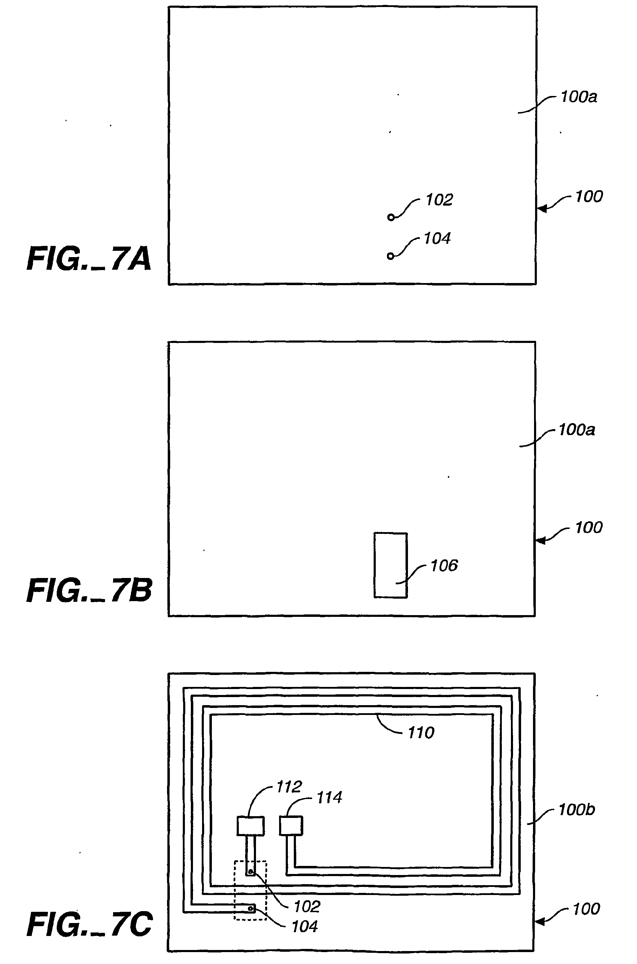

Figures 7 to 12 are provided to aid understanding of the technology surrounding the invention and are provided for background information only.

Figures 7A-7C illustrate an example cited to understand the present invention. In Figure 7A, a flexible substrate 100 is provided. Holes 102 and 104 are punched into the flexible substrate material 100. Looking at Figure 7B, a conductive foil 106 is attached over holes 102 and 104. Figures 7A and 7B are shown with side 100a of the flexible substrate 100 shown on top. In Figure 7C, the flexible substrate 100 is flipped to the other side 100b. In this side, the conductive Ink layer 110 forms a coil pattern. The shunt 106 on side 100a of the flexible substrate 100 allows that the pads 112 and 114 can be adjacent to one another for easy connection to the integrated circuit(IC) (Not shown). By using the metal foil shunt 106, the loops of the coil pattern on the radio frequency antenna need not be positioned between pads 112 and 114. Next an electroplating step can be done to form an electroplated conductive layer on top of the conductive ink coil pattern.

The conductive ink material easily flows inside relatively small holes used to connect between the conductive shunt 106 and the top side of the flexible substrate 100.

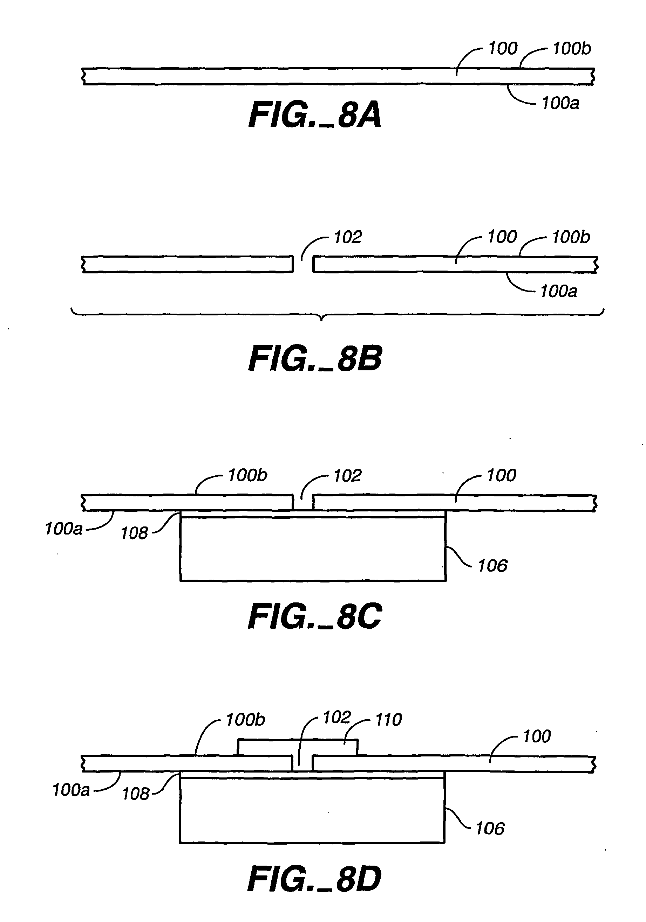

Figures 8A-8D are cross-sectional views illustrating the construction of the system Figures 7A-7C. Figure 8A illustrates the flexible substrate 100. In Figure 8B, a hole 102 is formed in the flexible substrate 100. In Figure 8C, the conductive foil material 106 is connected to the substrate 100. A conductive adhesive 108 can be used to hold the metal foil material 106 to the substrate 100. Figure 8B is shown with the conductive ink material 110 which enters the hole 102 to form an electrical contact with the shunt 106. The electrically conductive ink material easily flows into the hole 102. Note that the use of a shunt may make non-plated ink antennae feasible. The use of the shunt allows the resistance of the antenna to be reduced which can make it feasible to use a non-plated conductive ink layer. The shunt also allows for the conductive antenna coil pattern to be formed on both sides of the substrate layer, allowing for a thicker printed pattern. Here only a single hole is used. It is also possible for a system with an internal capacitor in the substrate layer forming a return path.

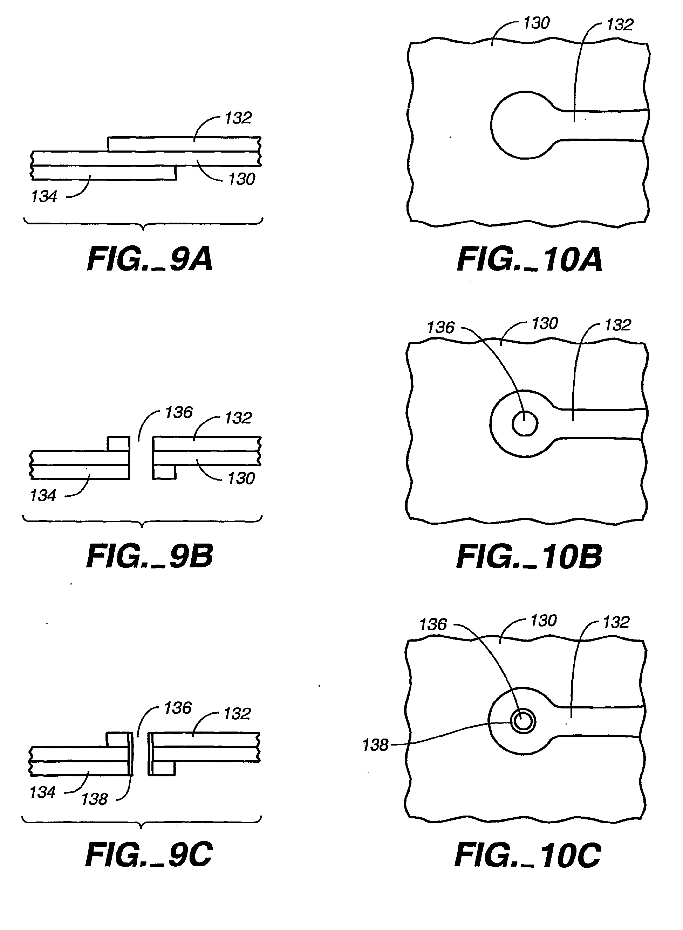

For further understanding an example of the conductive ink printing which does not require a metal conductive shunt on one side of the substrate is shown with respect to Figures 9-12. Figure 9A shows the substrate 130 with a first conductive ink layer 132 on a first side and a second conductive ink layer 134 on the second layer. Figure 10A shows a top view of the first conductive ink layer 132 and the substrate 130. Looking at Figure 9B, in this example a hole 136 is formed through the substrate and the first and second: conductive ink layers. This hole 136 is shown in the cross-sectional view of Figure 9B and the top view of Figure10B. Figure 9C shows the conductive ink placed within the hole 136 electrically conducting between the top conductive ink layer 132 and the bottom conductive ink layer 134. This conductive ink layer wicks around the side of the hole 136. No backing need be used, and a pad containing conductive ink is placed over the top of one side of the hole. The ink then wicks between the top and the bottom portions of the substrate, interconnecting the top and bottom conductive pads.

In this example it is important to keep the hole 136 open so that it can allow for plating within the hole 136 with a more highly conductive material, as described above.

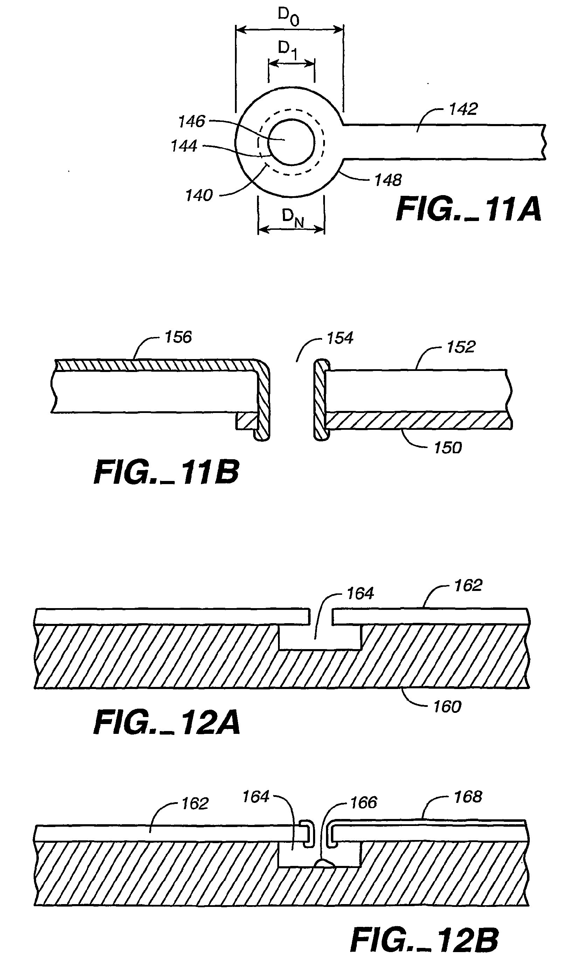

Figures 9-10 illustrate the situation wherein the ink is placed within the hole after the top and bottom conductive layer on the substrate are formed. Figures 11A and 11B, illustrates the situation in which the forming of the conductive ink within the hole is part of the forming of one of the conductive layers on top of the substrate. A possible disadvantage is that the conductive ink from this design placed on top of the substrate will flow through the hole too much, and either drip upon the backing or completely fill the hole, thus preventing the effective plating step. Figure11A illustrates a design for printing a portion of the conductive ink layer on a substrate around a previously-formed hole 146. In this case, the outer screen printing has a region that does not provide ink to at least a portion of the hole region 140. In this example the design has an inner diameter 144 that is within the diameter of the hole 140, so that some ink will flow into the hole. However, the ink does not extend into the inner region 146 of the hole. The design 142 has an outer diameter 148 which is greater than the diameter of the hole 140. Note that there could be a situation in which the flow of the ink is such that the diameter 144 could be greater than the diameter of the hole itself. By using the region 146, which is not screen-printed into the hole, the amount of ink provided into the hole can be reduced, thus reducing some of the potential problems with the pooling of the conductive ink. Figure11B illustrates the situation in which a conductive ink layer 150 is formed on one side of the substrate 162. A hole 154 is formed within the substrate 152, and thereafter another conductive ink layer 156 is used. This conductive ink layer is arranged to flow into the sides of the hole 154 and can contact the other conductive ink layer 150.

Figures 12A and 12B illustrate the use of a backing element 160 in the screen printing of the substrate 162. The backing 160 has a cavity 164. This cavity 164 allows ink 166 to pool at the bottom of the cavity 164. Because of the cavity 164, the pooled ink will not contact the substrate 162 or another substrate that uses the same backing. If the backing did not have a cavity 164, the ink could tend to pool at the bottom of the holes, and thus smear onto the present substrate or an additional substrate. The substrate 162 in Figure 12B illustrates the forming of a conductive layer 168.
Examples of the like given above would comprises the steps of :
1. Depositing a short layer on the substrate. The short layer can be either continuous or segmented.
2. Depositing a segmented plating resister layer.
3. Depositing a conductive seed layer such that the seed layer contacts the short layer through the segmented plating resist.
4. Plating the seed layer.
Or alternatively:
1. Drilling vias in the substrate in the path of the coil turns.
2. Depositing a conductive seed layer on the"A"side of the substrate. The coil pattern is configured to allow ink to flow down the side walls of the vias.
3. Depositing a conductive short layer on the"B"side of the substrate, making contact with the seed layer through the vias.
4. Depositing plating resist ink to mask the short layer on the"B"side.
5. Plating the seed layer.

The above description is meant to be exemplary only. Additional ways of implementing the invention are done within the scope of the present invention, which is to be limited only by the appended claims.

## Claims

1. A method of forming an RF antenna (40), comprising the following sequence of steps:
a first step (80) of providing a substrate layer (52);
a second step (82) of forming an antenna coil pattern (42) as a seed layer (50) on top of the substrate (52)
**characterised in that** the method further comprises the further sequence of steps;
a third step (86) of forming an electrical-short layer (54,46) over portions (148,150,152) of the antenna coil pattern (42) electrically shunting the portions of the coil pattern:
a fourth step (90) of using the electrical-short layer (54,46) to electroplate a conductive layer (58) over at least part of the antenna coil pattern (42); and
a fifth step (92) of removing the electrical-short layer (54,46) forming a region (72) with increased resistance over the portions (148,150,152) of the antenna coil pattern.

2. The method of claim 1 wherein the electrical-short layer is formed across points of the antenna coil pattern.

3. The method of any preceding claim wherein the seed layer (50,110) comprises a conductive ink layer.

4. The method of claim 3 wherein the conductive ink layer is cured.

5. The method of claim 3 wherein a non-conductive layer (56) is formed over the top of the electrical-short layer (46,54) before the electroplating step (50).

6. The method of claim 1 wherein the fifth step (92) of removing comprises using a solvent to remove the electrical-short layer (46,54).

7. The method of claim 1 wherein during the fifth step (92) of removing, the electrical-short layer (46,54) is differentially removable from the seed layer (50) .

8. The method of claim 1 wherein during the third step (86) of forming, the electrical-short layer (46,54) comprises a line across one section of the antenna coil pattern (42).

9. The method of claim 1 further comprising a step of forming at least one hole (102,104) in the substrate layer (52,100).

10. The method of claim 9. further comprising on a first side of the substrate layer (52,100), a step of attaching a conductive foil material (106) such that the conductive foil covers one side of the at least one hole (102, 104).

11. The method of claim 10 wherein the seed layer (50) is at least partially placed onto the at least one hole (102,104).

12. An RF antenna comprising:
a substrate layer (100, 52);
an antenna coil pattern (42) as a seed layer (50) on top of the substrate (100,52); a conductive layer (58) electroplated on portions (148, 150, 152) of the antenna coil pattern (42) **characterised in that** the antenna coil pattern (42) has a region (72) with increased resistance across the portions (148, 150, 152) of the coil pattern (42), the region (72) comprising a portion (62) of the seed layer (50,110) not covered by the conductive layer (58)

13. An RF antenna according to claim 12 wherein the conductive layer is arranged across points of the antenna coil pattern.

14. The RF antenna of claim 12 wherein the region (72) includes adjacent sections on the antenna coil pattern (42).

15. The RF antenna of claim 12 wherein the seed layer (50) comprises a cured conductive ink layer.

16. The RF antenna of claim 12 wherein an additional electroplate layer (60) covers the conductive layer (58) and said region (72).

## Patentansprüche

1. Verfahren zur Herstellung einer HF-Antenne (40), das folgende Sequenz von Schritten umfasst:
einen ersten Schritt (80) der Bereitstellung einer Substrat-Schicht (52); einen zweiten Schritt (82) der Herstellung eines Antennen-Spiralmusters (42) als Anfangs-Schicht (50) auf dem Substrat (52), **dadurch gekennzeichnet, dass** das Verfahren ferner die weitere Sequenz von Schritten umfasst:
einen dritten Schritt (86) der Herstellung einer elektrischen Kurzschluss-Schicht (54, 46) über Teilen (148, 150, 152) des Antennen-Spiralmusters (42), das die Teile des Spiralmusters überbrückt;
einen vierten Schritt (90) der Benutzung der elektrischen Kurzschluss-Schicht (54, 46), um eine leitfähige Schicht (58) über mindestens einem Teil des Antennen-Spiralmusters (42) zu galvanisieren; und
einen fünften Schritt (92) des Entfernens der elektrischen Kurzschluss-Schicht (54, 46), die über den Teilen (148, 150, 152) des Antennen-Spiralmusters einen Bereich (72) mit erhöhtem Widerstand bildet.

2. Verfahren nach Anspruch 1, **dadurch gekennzeichnet, dass** die elektrische Kurzschluss-Schicht über Punkten des Antennen-Spiralmusters hergestellt wird.

3. Verfahren nach einem der vorherigen Ansprüche, **dadurch gekennzeichnet, dass** die Anfangs-Schicht (50, 110) eine Schicht aus leitfähiger Druckfarbe ist.

4. Verfahren nach Anspruch 3, **dadurch gekennzeichnet, dass** die Schicht aus leitfähiger Druckfarbe ausgehärtet ist.

5. Verfahren nach Anspruch 3, **dadurch gekennzeichnet, dass** vor dem Galvanisierungs-Schritt (50) eine nicht leitfähige Schicht (56) über der elektrischen Kurzschluss-Schicht (46, 54) hergestellt wird.

6. Verfahren nach Anspruch 1, **dadurch gekennzeichnet, dass** der fünfte Schritt (92) des Entfernens die Verwendung eines Lösungsmittels umfasst, um die elektrische Kurzschluss-Schicht (46, 54) zu entfernen.

7. Verfahren nach Anspruch 1, **dadurch gekennzeichnet, dass** während des fünften Schritts (92) des Entfernens die elektrische Kurzschluss-Schicht (46, 54) unterschiedlich von der Anfangs-Schicht (50) entfernt werden kann.

8. Verfahren nach Anspruch 1, **dadurch gekennzeichnet, dass** während des dritten Schritts (86) der Herstellung die elektrische Kurzschluss-Schicht (46, 54) eine Leitung über einem Teil des Antennen-Spiralmusters (42) umfasst.

9. Verfahren nach Anspruch 1, **dadurch gekennzeichnet, dass** es weiterhin einen Schritt der Herstellung mindestes eines Lochs (102, 104) in der Substrat-Schicht (52, 100) umfasst.

10. Verfahren nach Anspruch 9, **dadurch gekennzeichnet, dass** es weiterhin einen Schritt umfasst, auf einer ersten Seite der Substrat-Schicht (52, 100) ein leitfähiges Folien-Material (106) zu befestigen, so dass die leitfähige Folie eine Seite des mindestens einen Lochs (102, 104) bedeckt.

11. Verfahren nach Anspruch 10, **dadurch gekennzeichnet, dass** die Anfangs-Schicht (50) mindestens teilweise auf dem mindestens einen Loch (102, 104) platziert wird.

12. HF-Antenne, die folgendes umfasst:
Eine Substrat-Schicht (100, 52);
ein Antennen-Spiralmuster (42) als Anfangs-Schicht (50) auf dem Substrat (100, 52); eine leitfähige Schicht (58), die auf Teilen (148, 150, 152) des Antennen-Spiralmusters (42) galvanisiert ist, **dadurch gekennzeichnet, dass** das Antennen-Spiralmuster (42) einen Bereich (72) mit erhöhtem Widerstand über den Teilen (148, 150, 152) des Spiralmusters (42) aufweist, wobei der Bereich (72) einen Teil (62) der Anfangs-Schicht (50, 110) umfasst, der nicht von der leitfähigen Schicht (58) bedeckt ist.

13. HF-Antenne nach Anspruch 12, **dadurch gekennzeichnet, dass** die leitfähige Schicht über Punkten des Antennen-Spiralmusters angeordnet ist.

14. HF-Antenne nach Anspruch 12, **dadurch gekennzeichnet, dass** der Bereich (72) benachbarte Abschnitte des Antennen-Spiralmusters (42) umfasst.

15. HF-Antenne nach Anspruch 12, **dadurch gekennzeichnet, dass** die Anfangs-Schicht (50) eine ausgehärtete Schicht aus leitfähiger Druckfarbe ist.

16. HF-Antenne nach Anspruch 12, **dadurch gekennzeichnet, dass** eine zusätzliche Galvanisierungs-Schicht (60) die leitfähige Schicht (58) und den genannten Bereich (72) bedeckt.

## Revendications

1. Procédé de formation d'une antenne HF (40), comprenant la séquence d'étapes suivante :
une première étape (80) consistant à procurer une couche de substrat (52),
une seconde étape (82) consistant à former un motif de bobine d'antenne (42) sous la forme d'une couche de germes (50) sur la partie supérieure du substrat (52)
**caractérisé en ce que** le procédé comprend en outre la séquence d'étapes supplémentaire :
une troisième étape (86) consistant à former une couche de court-circuit (54, 46) sur des parties (148, 150, 152) du motif de bobine d'antenne (42) shuntant électriquement les parties du motif de bobine,
une quatrième étape (90) consistant à utiliser la couche de court-circuit (54, 46) pour électroplaquer une couche conductrice (58) sur au moins une partie du motif de bobine d'antenne (42), et
une cinquième étape (92) consistant à éliminer la couche de court-circuit électrique (54, 46) en formant une région (72) présentant une résistance accrue sur les parties (148, 150, 152) du motif de bobine d'antenne.

2. Procédé selon la revendication 1, dans lequel la couche de court-circuit électrique est formée sur des points du motif de bobine d'antenne.

3. Procédé selon l'une quelconque des revendications précédentes, dans lequel la couche de germes (50, 110) comprend une couche d'encre conductrice.

4. Procédé selon la revendication 3, dans lequel la couche d'encre conductrice est polymérisée.

5. Procédé selon la revendication 3, dans lequel une couche non-conductrice (56) est formée sur la partie supérieure de la couche de court-circuit électrique (46, 54) avant l'étape d'électroplaquage.

6. Procédé selon la revendication 1, dans lequel la cinquième étape (92) d'élimination comprend l'utilisation d'un solvant pour éliminer la couche de court-circuit électrique (46, 54).

7. Procédé selon la revendication 1, dans lequel au cours de la cinquième étape (92) d'élimination, la couche de court-circuit électrique (46, 54) peut être éliminée de manière différentielle par rapport à la couche de germes (50).

8. Procédé selon la revendication 1, dans lequel, au cours de la troisième étape (86) de formation, la couche de court-circuit électrique (46, 54) comprend une ligne au travers d'une section du motif de bobine d'antenne (42).

9. Procédé selon la revendication 1, comprenant en outre une étape consistant à former au moins un trou (102, 104) dans la couche de substrat (52, 100).

10. Procédé selon la revendication 9, comprenant en outre sur un premier côté de la couche de substrat (52, 100) une étape consistant à fixer un matériau en feuille conducteur (106), de sorte que la feuille conductrice recouvre un côté du au moins un trou (102, 104).

11. Procédé selon la revendication 10, dans lequel la couche de germes (50) est au moins partiellement placée sur le au moins un trou (102, 104).

12. Antenne HF comprenant :
une couche de substrat (100, 52),
un motif de bobine d'antenne (42) en tant que couche de germes (50) sur la partie supérieure du substrat (100, 52), une couche conductrice (58) électroplaquée sur des parties (148, 150, 152) du motif de bobine d'antenne (42) **caractérisée en ce que** le motif de bobine d'antenne (42) comporte une région (72) présentant une valeur ohmique accrue au travers des parties (148, 150, 152) du motif de bobine (42), la région comprenant une partie (62) de la couche de germes (50, 110) non recouverte par la couche conductrice (58).

13. Antenne HF selon la revendication 12, dans laquelle la couche conductrice est disposée de part et d'autres de points du motif de bobine d'antenne.

14. Antenne HF selon la revendication 12, dans laquelle la région (72) comprend des sections adjacentes sur le motif de bobine d'antenne (42).

15. Antenne HF selon la revendication 12, dans laquelle la couche de germes (50) comprend une couche d'encre conductrice polymérisée.

16. Antenne HF selon la revendication 12, dans laquelle une couche d'électroplaquage supplémentaire (60) recouvre la couche conductrice (58) et ladite région (72).
